# EUROPEAN PATENT APPLICATION

(11) **EP 4 626 144 A1**
(43) Date of publication of application: **01.10.2025**
(21) Application number: 25158254.0
(22) Date of filing: 17.02.2025
(51) Int. Cl.: H05K 1/02, H05K 1/18, H01L 23/64, H02M 7/00, H01L 23/538

(54) **INVERTER DEVICE**

(30) Priority: 28.03.2024 JP 2024053402
(71) Applicant: MAZDA MOTOR CORPORATION, Hiroshima 730-8670 (JP)
(72) Inventor: Furukawa, Akihiro, Aki-gun, Hiroshima, 730-8670 (JP); Togashi, Shigenori, Sagamihara, Kanagawa, 252-0243 (JP)
(74) Representative: Behr, Wolfgang

(57) **Abstract**

An inverter device includes: an interconnect substrate having a first interconnect layer, a second interconnect layer, and a third interconnect layer; a first transistor and a second transistor, each having a source region and a drain region surrounding the source region on one face, arranged in a middle layer of the interconnect substrate; and a capacitor. A first power line extends from the one terminal of the capacitor in a first direction and is connected to the drain of the first transistor on the first-direction side of the source region. An output interconnect connected to the source of the first transistor extends in a second direction and is connected to the drain of the second transistor on the first-direction side of the source region. A second power line extends from the other terminal of the capacitor in the second direction and is connected to the source of the second transistor.

## Description

### BACKGROUND

The technology disclosed herein belongs to a technical field related to an inverter device.

As inverter devices are becoming increasingly higher in power output with the improvement in power density, a technology for reducing the inductance of the inverter devices is being required.

Japanese Unexamined Patent Publication No. 2003-259656 describes a technology in which, in an inverter of DC-AC conversion, in order to reduce the interconnect inductance, two interconnect conductors are placed in parallel and close to each other and currents in the opposite directions are passed through the conductors, whereby the interconnect inductance is reduced using the mutual inductance.

Conventional inverter devices are formed by mounting transistors on a surface of a substrate. However, in the mounting of transistors on a substrate surface, there arises a problem of failing to sufficiently reduce the self-inductance due to the influence of bonding wires connecting the transistors and the substrate.

In view of the above problem, an objective of the technology disclosed herein is providing an inverter device with a reduced inductance.

### SUMMARY

According to one mode of the technology disclosed herein, an inverter device includes: an interconnect substrate with a first interconnect layer, a second interconnect layer, and a third interconnect layer stacked one upon another; a first transistor and a second transistor, each having a source region and a drain region surrounding the source region on one face, arranged side by side in a middle layer between the second interconnect layer and the third interconnect layer so that the one face faces the second interconnect layer; and a capacitor with one terminal connected to a first power line in the first interconnect layer and the other terminal connected to a second power line in the first interconnect layer, wherein the first power line extends from the one terminal of the capacitor in a first direction in the first interconnect layer and is connected to a drain of the first transistor, an output interconnect connected to a source of the first transistor extends in a second direction opposite to the first direction in the second interconnect layer and is connected to a drain of the second transistor, and the second power line extends from the other terminal of the capacitor in the second direction in the first interconnect layer and is connected to a source of the second transistor.

With the above configuration, when focusing on a loop circuit formed by the capacitor, the first transistor, and the second transistor, a physically small loop can be achieved, and therefore the self-inductance can be reduced. Moreover, the direction of the current flowing in the first power line in the first interconnect layer and the direction of the current flowing in the output interconnect can be made opposite to each other. Similarly, the direction of the current flowing in the output interconnect and the direction of the current flowing in the second power line in the first interconnect layer can be made opposite to each other. With this, since a mutual inductance part is subtracted from the self-inductance, the value of the synthetic inductance can be reduced. Having the configuration of this embodiment, therefore, the inverter device can achieve both low inductance and high thermal conductivity.

As described above, according to the technology disclosed herein, the inductance of the inverter device can be reduced.

### BRIEF DESCRIPTION OF THE DRAWINGS

FIG. 1 is a circuit diagram of an inverter device.
FIG. 2 is a sectional side view showing an example of the configuration of the inverter device.
FIG. 3 is a plan view of the inverter device as viewed from above a second interconnect layer.
FIG. 4 is a bottom view of the inverter device as viewed from below a fifth interconnect layer.
FIG. 5 is a view for explaining the flow of a current in the inverter device.
FIG. 6 is a sectional side view, equivalent of FIG. 2, showing another configuration example 1 of the inverter device.
FIG. 7 is a sectional side view, equivalent of FIG. 2, showing yet another configuration example 2 of the inverter device.
FIG. 8 is a plan view of the inverter device as viewed from above a first interconnect layer.
FIG. 9 is a cross-sectional view taken along line IX-IX in FIG. 8.

### DETAILED DESCRIPTION

An illustrative embodiment will be described hereinafter with reference to the accompanying drawings. Note that the following description of the embodiment is merely illustrative essentially and will be made centering on the configuration related to the subject matter of the technology disclosed. Also, although technical elements different from the subject matter of the technology disclosed may be illustrated or described briefly, or description of such elements may be omitted, this will never be intended to limit the scope of the technology disclosed. In the present disclosure, the term "connection" is used as a concept broadly encompassing the state of being electrically connected. For example, the term "connection" includes, not only the case of direct connection between elements, but also the case of indirect connection between elements through a via or the like.

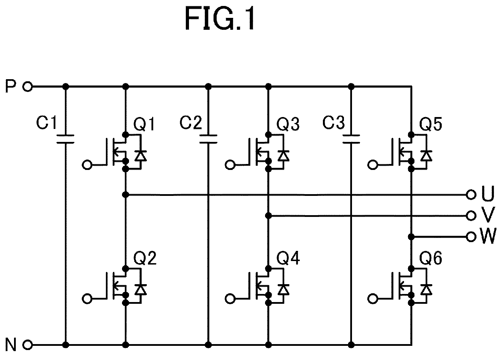

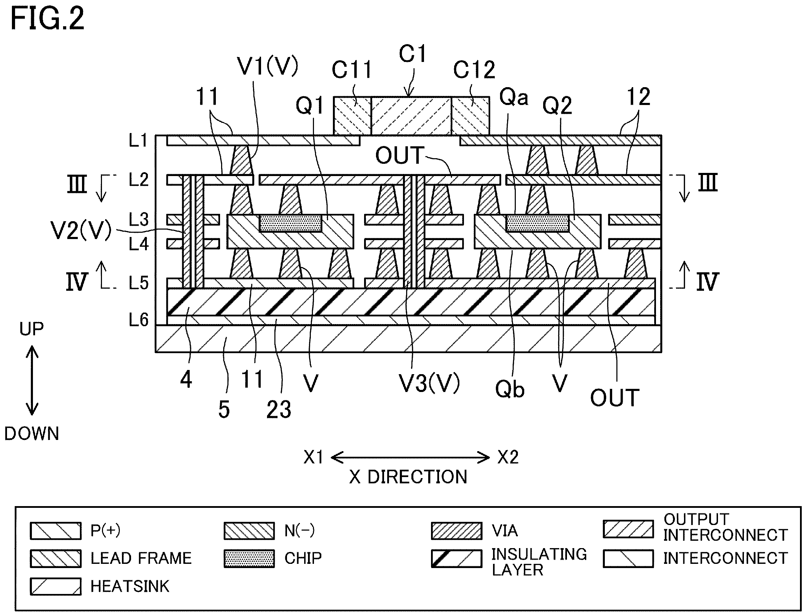

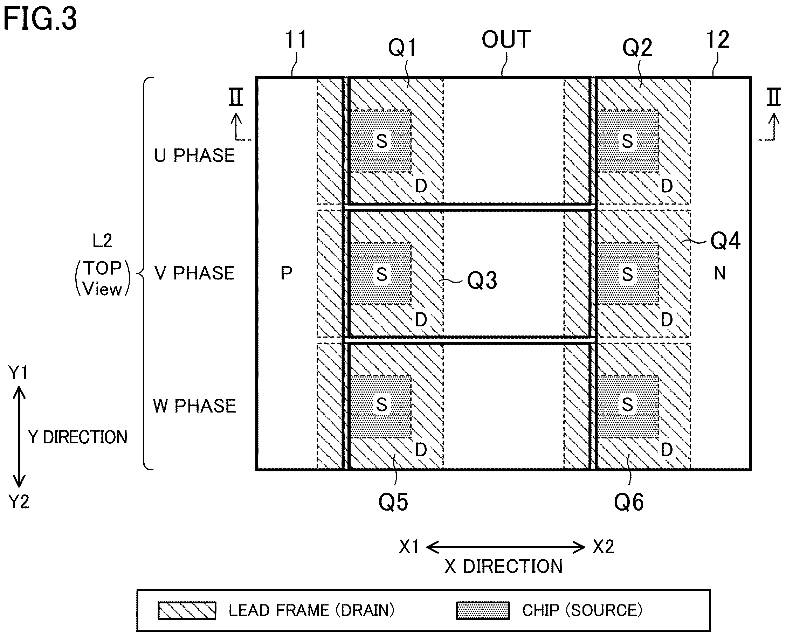

FIG. 1 is a circuit diagram of an inverter device according to an embodiment. FIG. 2 is a sectional side view (e.g., a cross-sectional view taken along line II-II in FIG. 3) showing a configuration of the inverter device.

As shown in FIG. 1, in this example, the inverter device 1 is a 2-level inverter that outputs AC of three phases (U phase, V phase, and W phase) from a DC power supply such as a battery (not shown). The uses of the inverter device 1 are not specifically limited, but include driving of automobiles and actuation of engines (e.g., an integrated starter generator (ISG)), for example.

As shown in FIGS. 1 and 2, the inverter device 1 includes an interconnect substrate 2, transistors Q1 to Q6, and capacitors C1 to C3. Note that, in the following description, the transistors Q1 to Q6 may be collectively called the "transistors Q" when described with no distinction. Similarly, the capacitors C1 to C3 may be collectively called the "transistors C" when described with no distinction.

### -Interconnect Substrate-

The interconnect substrate 2 is a multi-layer interconnect substrate (e.g., a printed board) having six interconnect layers, for example. For convenience of description, as shown in FIG. 2, the thickness direction of the interconnect substrate is defined as the up/down direction, and the interconnect layer (first interconnect layer) having the principal surface (uppermost face) on which the capacitors C1 to C3 are placed is called an interconnect layer L1. From the interconnect layer L1 downward, interconnect layers L2 to L6 (second to sixth interconnect layers) are formed in this order with an insulating layer (e.g., a layer formed of resin) interposed between every adjacent interconnect layers. From the standpoint of improving heat dissipation performance, it is preferable to use a glass epoxy resin or a high thermal conductive resin for the insulating layer between the interconnect layer L5 and the interconnect layer L6. FIG. 2 shows an example using a TIM as an insulating layer 4 between the interconnect layer L5 and the interconnect layer L6. Also, a heatsink 5 is stuck on the bottom face of the interconnect layer L6.

### -Capacitor-

The capacitors C1 to C3 are provided between a first power line 11 to which a positive power supply voltage P(+) is supplied from a battery (not shown) or the like and a second power line 12 to which a negative power supply voltage N(-) is supplied. The capacitor C1 is a capacitor for U phase and provided in parallel with a serial circuit of the transistor Q1 and the transistor Q2. The capacitor C2 is a capacitor for V phase and provided in parallel with a serial circuit of the transistor Q3 and the transistor Q4. The capacitor C3 is a capacitor for W phase and provided in parallel with a serial circuit of the transistor Q5 and the transistor Q6.

### -Transistor-

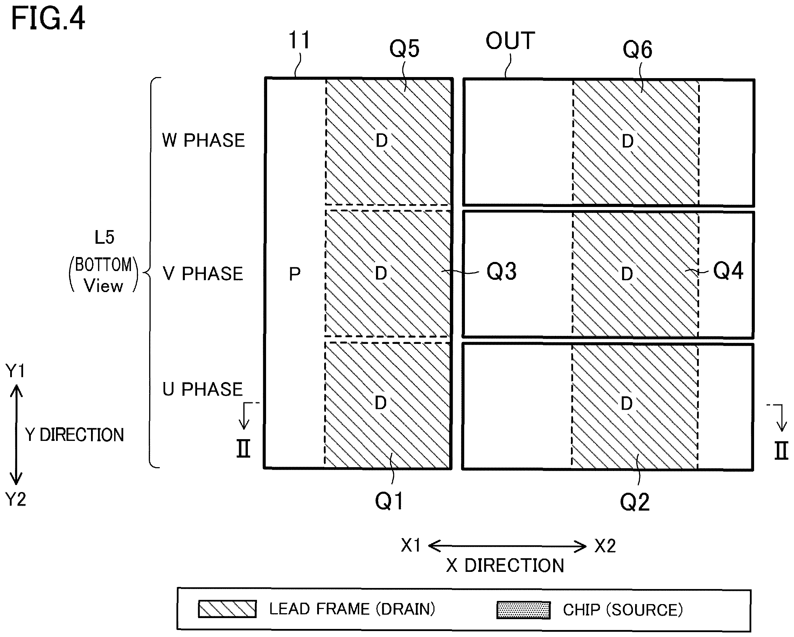

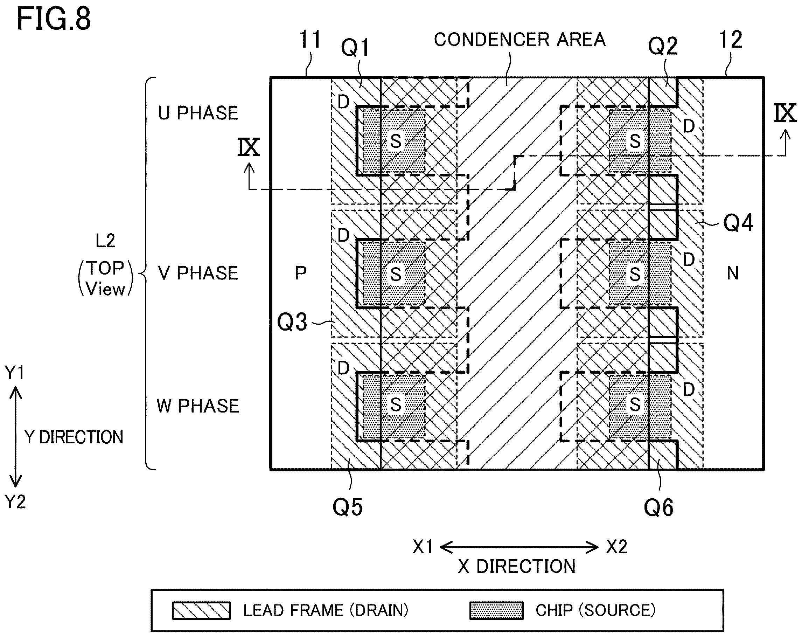

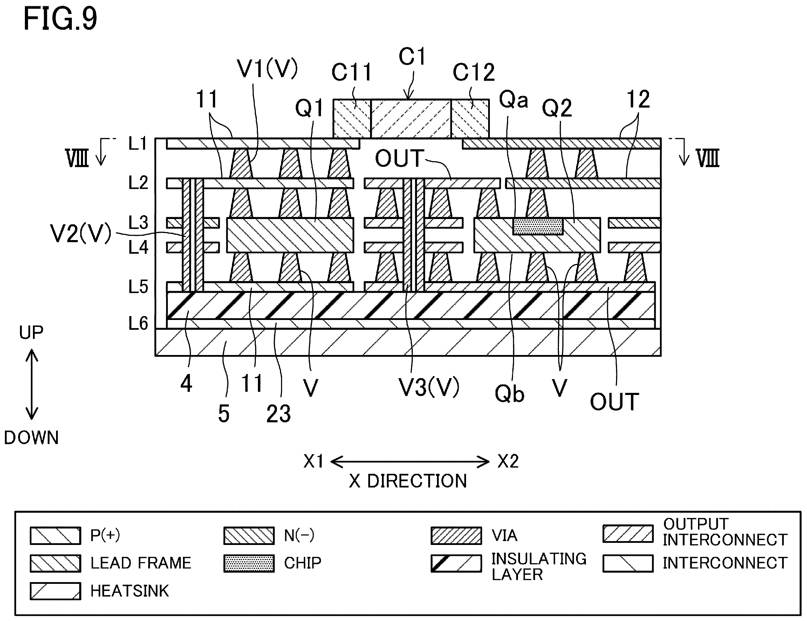

FIG. 3 is a plan view of the inverter device 1 as viewed from above the interconnect layer L2, and FIG. 4 is a bottom view of the inverter device 1 as viewed from below the interconnect layer L5. FIG. 8 is a plan view of the inverter device 1 as viewed from above the interconnect layer L1, and FIG. 9 is a cross-sectional view taken along line IX-IX in FIG. 8. In FIGS. 3, 4, and 8, the positions of the transistors Q1 to Q6 are indicated by the broken lines. Note that, as shown in FIGS. 3, 4, and 8, the X direction and the Y direction are defined as directions perpendicular to the up/down direction and also orthogonal to each other. Also, in the following description, out of the X direction, the leftward direction in FIG. 3 may be called the X1 direction and the rightward direction in FIG. 3 called the X2 direction. Also, out of the Y direction, the upward direction in FIG. 3 may be called the Y1 direction and the downward direction in FIG. 3 called the Y2 direction.

As shown in FIGS. 2 to 4, 8, and 9, the transistors Q1 to Q6 of U phase, V phase, and W phase are placed in a middle layer between the interconnect layer L2 and the interconnect layer L5. In this example, the interconnect layer L3, the interconnect layer L4, and an insulating layer between the interconnect layers L3 and L4 correspond to the "middle layer." Specifically, the transistors Q1 to Q6 are arranged in the X-Y directions in the middle layer in planar view. In this example, the transistors Q1 and Q2 of U phase, the transistors Q3 and Q4 of V phase, and the transistors Q5 and Q6 of W phase are individually arranged side by side in the X direction, and the set of the transistors Q1 and Q2 of U phase, the set of the transistors Q3 and Q4 of V phase, and the set of the transistors Q5 and Q6 of W phase are arranged in the Y2 direction in the order of U phase, V phase, and W phase.

The transistors Q are each an n-type power MOSFET of a vertical structure, and in this example, constituted by a semiconductor chip Qa (simply indicated as a "chip" in the figures) and a lead frame Qb. The semiconductor chip Qa has a source on one face and a drain on the other face. The lead frame Qb, made of copper, for example, is formed to have a U-shape in sectional side view (see FIG. 2) to cover the other face (drain) of the semiconductor chip Qa, and connected to the drain of the semiconductor chip Qa. That is, the lead frame Qb and the drain of the semiconductor chip Qa have the same potential.

In other words, the transistor Q has a source region S in which a source terminal is provided and a drain region D in which a drain terminal is provided to surround the source region S on one face, and has the drain terminal formed entirely on the other face. Note that the "terminal" is used herein to mean an inlet/outlet of a current, and its specific form and mode are not specifically limited. Also, for convenience of description, the source terminal may be simply called the "source" and the drain terminal simply called the "source" hereinafter.

In this example, the source region S has a rectangular shape and the drain region D is provided to surround the source region S as a rectangular frame. However, the shape of the source region S is not limited to the rectangle. Similarly, the drain region D is not necessarily required to surround the source region S entirely, but may be partly discontinued. In the following description, the one face is called the "source-drain face" and the other face is called the "drain face." Note that the gate of the transistor Q is formed on the source-drain face although illustration is omitted because it falls outside the subject matter of the technology disclosed.

Also, the source and drain of each transistor Q and interconnects formed in the interconnect layers L2 and L5 are connected through a plurality of vias V and the lead frame Qb. For convenience of description, however, description of the connections through the vias V and the lead frame Qb may be omitted hereinafter. This also applies to connections of interconnects between interconnect layers: i.e., illustration and/or description of connections through vias V and lead frames Qb may be omitted. Note also that, in FIGS. 2 and 9, for easy understanding of the drawing, common hatching is given to interconnects to which a common signal or voltage is applied. In other words, in FIGS. 2 and 9, interconnects under common hatching are mutually connected through vias and the like (whether shown or not shown).

The transistors Q1 to Q6 will be described individually hereinafter. Since the configurations of the transistors are the same among U phase, V phase, and W phase, description here will be made for one phase (U phase) only.

As shown in FIG. 2 or 9, the transistor Q1 is placed with the source-drain face facing the interconnect layer L2 and the drain face facing the interconnect layer L5, that is, positioned with the source-drain face facing upward. In the transistor Q1, the source is connected to an output interconnect OUT in the interconnect layer L2. Also, the drain on the source-drain face and the drain on the drain face are connected to the first power line 11 in the interconnect layer L2 and the interconnect layer L5, respectively. The transistor Q1 is placed so that the source region S on the source-drain face is located at a position in the X1 direction with respect to a terminal C11 (terminal on the X1-direction side) of the capacitor C1.

The transistor Q2 is placed with the source-drain face facing the interconnect layer L2 and the drain face facing the interconnect layer L5, that is, positioned with the source-drain face facing upward. In the transistor Q2, the source is connected to the second power line 12 in the interconnect layer L2. Also, the drain on the source-drain face and the drain on the drain face are connected to the output interconnect OUT in the interconnect layer L2 and the interconnect layer L5, respectively. The transistor Q2 is placed so that the source region S on the source-drain face is located at a position in the X2 direction with respect to a terminal C12 (terminal on the X2-direction side) of the capacitor C1.

Although detailed description is omitted, the transistors Q3 and Q4 of V phase are configured similarly to the transistors Q1 and Q2 of U phase, and also the transistors Q5 and Q6 of W phase are configured similarly to the transistors Q1 and Q2 of U phase.

### -Interconnect-

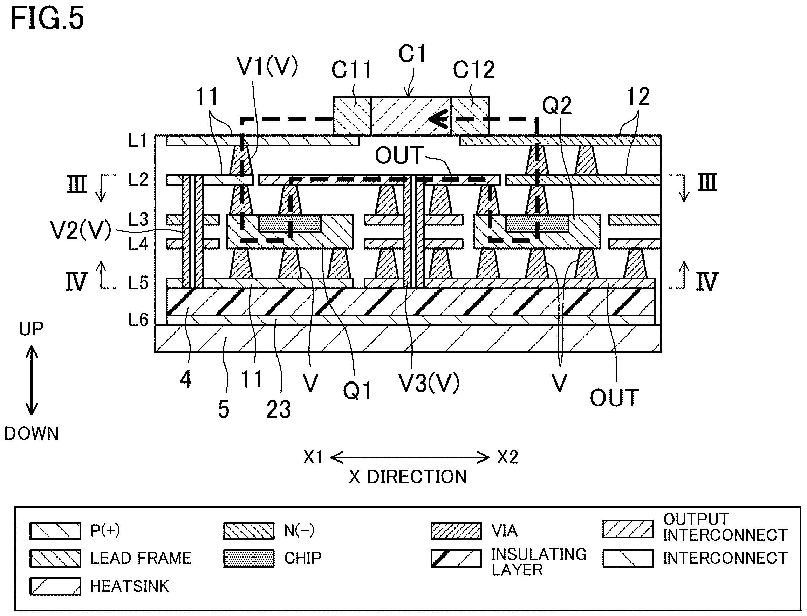

The first power line 11 is connected to one terminal C11 of the capacitor C1 in the interconnect layer L1, and extends from the terminal C11 in the X1 direction (corresponding to the first direction). Specifically, the first power line 11 has a length extending from the terminal C11 of the capacitor C1 to a position beyond the end of the transistor Q1 in the X1 direction. Also, the first power line 11 has a width larger than the transistor Q1 and is provided to cover the transistor Q1 in planar view. The first power line 11 in the interconnect layer L1 is connected to the first power line 11 in the interconnect layer L2 through a via V1 at a position in the X1 direction with respect to the source region S of the transistor Q1. The first power line 11 in the interconnect layer L2 is connected to the drain of the transistor Q1 in the drain region D on the X1-direction side of the source region S of the transistor Q1. Specifically, in the plan view of FIG. 3 or 8, the first power line 11 and the drain region D of the transistor Q1 are connected to each other in the overlap region of the first power line 11 with the drain region D of the transistor Q1. With this, a current in the X1 direction flows in the first power line 11 in the interconnect layer L1 (see FIG. 5).

Also, the first power line 11 in the interconnect layer L2 is connected to the first power line 11 in the interconnect layer L5 through a via V2 penetrating through interconnect layers. The first power line 11 in the interconnect layer L5 is connected to the drain of the transistor Q1 on the drain face of the transistor Q1. Specifically, in the bottom view of FIG. 4, the first power line 11 is connected to the drain of the transistor Q1 in the overlap region of the first power line 11 with the drain region D of the transistor Q1.

Although detailed description is omitted, the relationship between the first power line 11 and the transistor Q3 of V phase and the relationship between the first power line 11 and the transistor Q5 of W phase are also similar to that described above.

The output interconnect OUT is an interconnect formed in the interconnect layer L2 and the interconnect layer L5, and outputs power of each phase of the inverter device 1. As shown in FIG. 3, the output interconnect is placed to overlap the source region S of the transistor Q1 in planar view, and connected to the source of the transistor Q1 in the overlap region. The output interconnect OUT in the interconnect layer L2 further extends in the X2 direction (corresponding to the second direction) and is connected to the drain of the transistor Q2 in the drain region D on the X1-direction side of the source region of the transistor Q2. Specifically, in the plan view of FIG. 3, the output interconnect OUT extends to the drain region D on the X1-direction side of the source region of the transistor Q2, and is connected to the drain of the transistor Q2 in the overlap region with the drain region D of the transistor Q2. Also, there is provided a zone in which the first power line 11 in the interconnect layer L1 and the output interconnect OUT in the interconnect layer L2 overlap each other in planar view, lying one upon the other in parallel with each other. The largest possible width is secured as the overlap width in the Y direction between the first power line 11 in the interconnect layer L1 and the output interconnect OUT in the interconnect layer L2. With this, the effect of reducing the inductance by mutual inductance can be enhanced.

Moreover, the output interconnect OUT in the interconnect layer L2 is connected to the output interconnect OUT in the interconnect layer L5 through a via V3 penetrating through interconnect layers. The output interconnect OUT in the interconnect layer L5 is connected to the drain of the transistor Q2 on the drain face of the transistor Q2. Specifically, in the plan view of FIG. 4, the output interconnect OUT is connected to the drain of the transistor Q2 in the overlap region with the drain region D of the transistor Q2.

Although detailed description is omitted, the relationship between the output interconnect OUT and the transistor Q4 of V phase and the relationship between the output interconnect OUT and the transistor Q6 of W phase are similar to that described above.

The second power line 12 is connected to the other terminal C12 of the capacitor C1 in the interconnect layer L1, and extends from the terminal C12 in the X2 direction. The second power line 12 is also provided in the interconnect layer L2 through vias. The second power line 12 in the interconnect layer L2 is connected to the source of the transistor Q2 in the source region S of the transistor Q2. Specifically, in the plan view of FIG. 3 or 8, the second power line 12 is connected to the source of the transistor Q2 in the overlap region of the second power line 12 with the source region S of the transistor Q2. With this, a current in the X1 direction flows in the second power line 12 in the first interconnect layer L1. Also, there is provided a zone in which the second power line 12 in the interconnect layer L1 and the output interconnect OUT in the interconnect layer L2 overlap each other in planar view, lying one upon the other in parallel with each other. The largest possible width is secured as the overlap width in the Y direction between the second power line 12 in the interconnect layer L1 and the output interconnect OUT in the interconnect layer L2. With this, the effect of reducing the inductance by mutual inductance can be enhanced.

### -Effects of Embodiment-

As described above, the inverter device 1 of this embodiment includes the interconnect substrate 2 having the interconnect layer L1 (corresponding to the first interconnect layer), the interconnect layer L2 (corresponding to the second interconnect layer), and the interconnect layer L5 (corresponding to the third interconnect layer), a plurality of transistors Q arranged in a middle layer between the interconnect layer L2 and the interconnect layer L5 in the interconnect substrate 2, and the capacitors C.

When focusing on U phase, the first power line 11 extends from one terminal C11 of the capacitor C1 in the first direction in the interconnect layer L1, and is connected to the drain of the transistor Q1 in the drain region D on the X1-direction side of the source region S of the transistor Q1. The output interconnect OUT connected to the source of the transistor Q1 extends in the X2 direction in the interconnect layer L2 and is connected to the drain of the transistor Q2 in the drain region D on the X1-direction side of the source region S of the transistor Q2. The second power line 12 extends from the other terminal C12 of the capacitor C1 in the second direction in the interconnect layer L1, and is connected to the source of the transistor Q2. With this configuration, when focusing on a loop circuit formed by the capacitor C1, the transistor Q1, and the transistor Q2, a physically small loop can be achieved, whereby the self-inductance can be reduced.

Also, the first power line 11 in the interconnect layer L1, in which a current flows in the X1 direction, and the output interconnect OUT in the interconnect layer L2, in which a current flows in the X2 direction, extend in parallel with each other. Similarly, the output interconnect OUT in the interconnect layer L2, in which a current flows in the X2 direction, and the second power line 12 in the interconnect layer L1, in which a current flows in the X1 direction, extend in parallel with each other. That is, the directions of currents flowing in the parallel interconnects in the interconnect layer L1 and the interconnect layer L2 can be made opposite to each other. Therefore, since a mutual inductance part is subtracted from the self-inductance, the value of the synthetic inductance of the inverter device 1 can be reduced.

As described above, with the configuration of this embodiment, the inverter device 1 can achieve both low inductance and high thermal conductivity. For V phase and W phase, also, since the configuration is similar to that of U phase as described above, similar effects can be obtained.

Moreover, with the configuration of this embodiment, while the first power line 11, the second power line 12, and the output interconnect OUT are made wide, the inverter device 1 can be made compact and therefore can be downsized.

### <Other Embodiments>

As described above, the above embodiment is a mere illustration of the present disclosure and should not be construed to limit the scope of the present disclosure. The scope of the present disclosure is defined by the appended claims, and all modifications and changes belonging to the equivalence scope of the claims fall within the scope of the present disclosure.

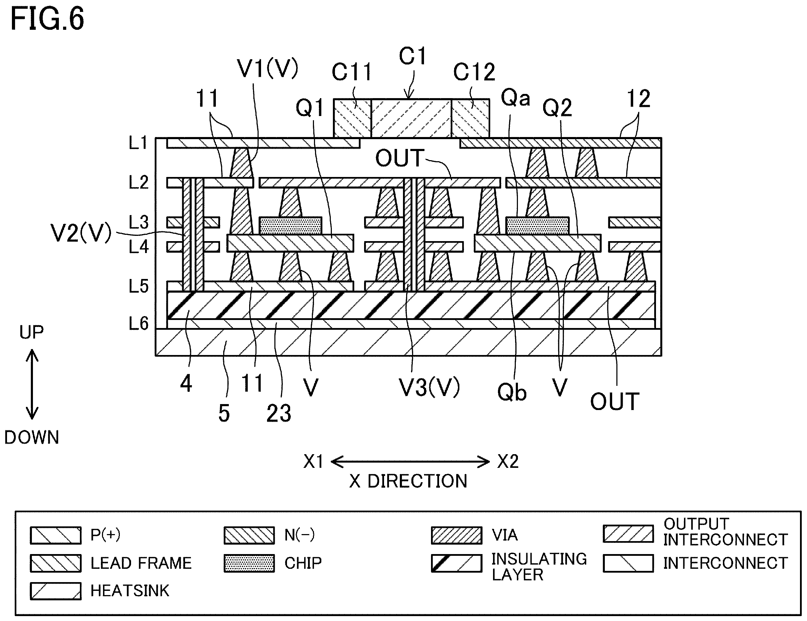

For example, in the above embodiment, while the transistors Q each include the lead frame Qb having a U-shape in sectional side view as shown in FIG. 2, the shape is not limited to this. For example, as shown in FIG. 6 (Alteration 1), the lead frame Qb may have a rectangular shape longer on both sides in the X direction than the semiconductor chip Qa in sectional side view. In this case, the width in the Y direction may be made larger on both sides in the Y direction than that of the semiconductor chip Qa as in the above embodiment, or may be the same as that of the semiconductor chip Qa.

In the configuration of FIG. 6, also, the drain (lead frame Qb) on the source-drain face of the transistor Q1 and the first power line 11 in the interconnect layer L2 are connected through a via V, for example. Similarly, the drain (lead frame Qb) on the source-drain face of the transistor Q2 and the output interconnect OUT in the interconnect layer L2 are connected through a via V. The other configuration is similar to that in FIG. 2.

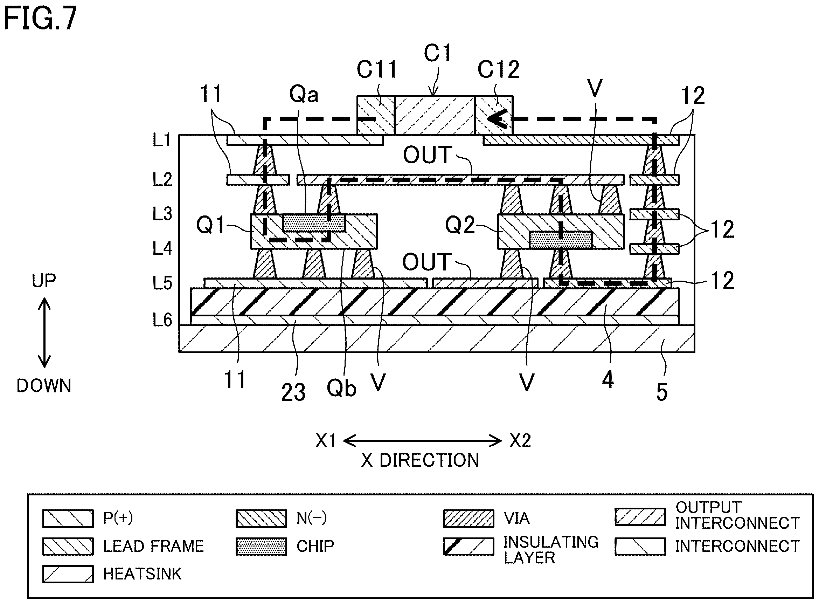

Also, as shown in FIG. 7 (Alteration 2), the transistor Q2 may be flipped vertically. In this case, the connection between the output interconnect OUT and the transistor Q2 and the connection between the transistor Q2 and the second power line 12 are different from those in the above embodiment. FIG. 7 is a cross-sectional view, equivalent of FIG. 2, of Alteration 2, and indicates the direction of the current flow by the broken line as in FIG. 5.

Specifically, the output interconnect OUT extends from the transistor Q1 to the drain region D of the transistor Q2 in the interconnect layer L2, and is connected to the drain of the transistor Q2 in the overlap region with the drain region D of the transistor Q2 in planar view. In Alteration 2, also, there is provided a zone in which the first power line 11 in the interconnect layer L1 and the output interconnect OUT in the interconnect layer L2 overlap each other in planar view, lying one upon the other in parallel with each other.

The source of the transistor Q2 is connected to the second power line 12 provided in the interconnect layer L5, and the second power line 12 in the interconnect layer L5 is connected to the second power line 12 in the interconnect layer L1 through vias or the like at a position in the X2 direction with respect to the source region of the transistor Q2. The second power line 12 in the interconnect layer L1 extends from the other terminal C12 of the capacitor C1 in the second direction as in the above embodiment. In other words, there is provided a zone in which the output interconnect OUT in the interconnect layer L2 and the second power line 12 in the interconnect layer L1 overlap each other in planar view, lying one upon the other in parallel with each other.

In the configurations of Alterations 1 and 2 described above, also, effects similar to those in the above embodiment are obtained. That is, the inverter device 1 can achieve both low inductance and high thermal conductivity.

The technology disclosed herein is very useful because the inductance of an inverter device can be reduced.

## Claims

1. An inverter device, comprising:
an interconnect substrate with a first interconnect layer, a second interconnect layer, and a third interconnect layer stacked one upon another;
a first transistor and a second transistor, each having a source region and a drain region surrounding the source region on one face, arranged side by side in a middle layer between the second interconnect layer and the third interconnect layer so that the one face faces the second interconnect layer; and
a capacitor with one terminal connected to a first power line in the first interconnect layer and the other terminal connected to a second power line in the first interconnect layer,
wherein
the first power line extends from the one terminal of the capacitor in a first direction in the first interconnect layer, and is connected to a drain of the first transistor in the drain region on a side of the source region of the first transistor in the first direction,
an output interconnect connected to a source of the first transistor extends in a second direction opposite to the first direction in the second interconnect layer and is connected to a drain of the second transistor in the drain region on a side of the source region of the second transistor in the first direction, and
the second power line extends from the other terminal of the capacitor in the second direction in the first interconnect layer, and is connected to a source of the second transistor.

2. The inverter device of claim 1, wherein
the first power lines in the second interconnect layer and the third interconnect layer are mutually connected through a via, and the first power line in the third interconnect layer is connected to the drain of the first transistor.

3. The inverter device of claim 1, wherein
the output interconnects in the second interconnect layer and the third interconnect layer are mutually connected through a via, and the output interconnect in the third interconnect layer is connected to the drain of the second transistor.

4. An inverter device, comprising:
an interconnect substrate with a first interconnect layer, a second interconnect layer, and a third interconnect layer stacked one upon another;
a first transistor and a second transistor, each having a source region on one face and a drain region on the other face, arranged side by side in a middle layer between the second interconnect layer and the third interconnect layer; and
a capacitor with one terminal connected to a first power line in the first interconnect layer and the other terminal connected to a second power line in the first interconnect layer,
wherein
the one face of the first transistor faces the second interconnect layer, and the other face of the second transistor faces the second interconnect layer,
the first power line extends from the one terminal of the capacitor in a first direction in the first interconnect layer and is connected to a drain of the first transistor,
an output interconnect connected to a source of the first transistor extends in a second direction opposite to the first direction in the second interconnect layer and is connected to a drain of the second transistor, and
the second power line extends from the other terminal of the capacitor in the second direction in the first interconnect layer and is connected to a source of the second transistor.
